# EUROPEAN PATENT APPLICATION

(11) **EP 1 473 841 A1**
(43) Date of publication of application: **03.11.2004**
(21) Application number: 03737468.3
(22) Date of filing: 03.02.2003
(51) Int. Cl.: H04B 1/18

(54) **SEMICONDUCTOR INTEGRATED CIRCUIT FOR RADIO APPARATUS AND RADIO COMMUNICATION APPARATUS**

(30) Priority: 07.02.2002 JP 2002030789
(71) Applicant: KABUSHIKI KAISHA TOYOTA JIDOSHOKKI, Kariya-shi, Aichi 448-8671 (JP); Niigata Seimitsu Co., Ltd., Joetsu-shi, Niigata 943-0834 (JP)
(72) Inventor: MIYAGI, Hiroshi c/o NIIGATA SEIMITSU CO., LTD., Joetsu-shi, Niigata 943-0834 (JP)
(74) Representative: Leson, Thomas Johannes Alois, Dipl.-Ing.
(86) International application number: PCT/JP2003/001073
(87) International publication number: WO 2003/067774

(57) **Abstract**

Adjustment data of first and second tracking adjustment circuits 11 and 12 are set in latch circuits 21 and 22. The plurality of pieces of adjustment data latched by the latch circuits 21 and 22 are respectively output to one D/A converter 41 at different time intervals. The data are converted into a direct current control voltage in the D/A converter 41, and the control voltage is respectively held by voltage holding circuits of the first tracking adjustment circuit 11 and the second tracking adjustment circuit 12, and a tuning frequency is adjusted. After an optimum tuning frequency is obtained, the tuning data at that time is written to a nonvolatile memory within an IC, and the control voltage is supplied to each tuning circuit based on the tuning data stored in the nonvolatile memory.

## Description

### Technical Field

The present invention relates to a semiconductor integrated circuit for a radio, and radio communications equipment.

### Background Art

In an AM/FM receiver, various types of adj ustments such as an adjustment of a tuning frequency for selecting a station, a removal of a pilot signal of a stereo signal, an adjustment of stereo separation for separating R and L signals from a stereo composite signal, an adjustment of a free run frequency of a VCO, etc. are required.

### Disclosure of Invention

There exists a receiver where part of a reception circuit is put into an IC. However, adjustments such as an adjustment of a tuning circuit, an adjustment of stereo separation, an adjustment of a free run frequency of a VCO, etc. were made by manually adjusting the capacitance of a capacitor which is an externally attached component, or the inductance of a coil.

An object of the present invention is to simplify a circuit configuration by reducing the number of D/A converters when the D/A converters for controlling the voltages of adjustment circuits are provided in a semiconductor integrated circuit for a radio, and to reduce consumed power.

A semiconductor integrated circuit for a radio according to the present invention comprises: one D/A converter, to which a plurality of pieces of digital adjustment data for adjusting the voltages of a plurality of adjustment circuits requiring a voltage adjustment are input at different time intervals on a time axis, converting the adjustment data into a direct current voltage, and outputting the voltage; and a voltage holding circuit, which is provided in each of the plurality of adjustment circuits, selectively holding the direct current voltage output from the D/A converter.

According to the present invention, adjustment data for adjusting the voltages of the plurality of adjustment circuits are input to the one D/A converter at different time intervals on a time axis, the adjustment data are converted into a direct current voltage, and the corresponding adjustment circuit can hold the direct current voltage. As a result, the number of D/A converters formed in the semiconductor integrated circuit can be decreased, and the consumed power of the circuit can be reduced.

Another semiconductor integrated circuit for a radio according to the present invention comprises: one D/A converter, to which at least two pieces of adjustment data among digital adjustment data for adjusting a tuning frequency, digital adjustment data for adjusting an oscillation frequency, and digital adjustment data for adjusting a signal level are input at different time intervals on a time axis, converting the adjustment data into a direct current voltage, and outputting the voltage; and a plurality of voltage holding circuits selectively holding the output voltage of the D/A converter.

According to the present invention, the adjustment data for adjusting a tuning frequency, the adjustment data for adjusting an oscillation frequency, etc. are input to the one D/A converter at different time intervals on a time axis, the adjustment data are converted into a direct current voltage, and the corresponding adjustment circuit can hold the direct current voltage. As a result, the number of D/A converters formed in the semiconductor integrated circuit can be decreased, and the consumed power of the circuit can be reduced.

A semiconductor integrated circuit for a radio according to the present invention comprises: a plurality of data holding circuits holding a plurality of pieces of digital adjustment data for adjusting the direct current voltages of a plurality of adjustment circuits requiring a voltage adjustment; a selection circuit outputting the adjustment data held by the plurality of data holding circuits at different time intervals on a time axis; one D/A converter converting the adjustment data output from the selection circuit into a direct current voltage; and a voltage holding circuit, which is provided in each of the adjustment circuits, selectively holding the output voltage of the D/A converter.

A semiconductor integrated circuit for a radio according to the present invention comprises: at least two data holding circuits holding at least two pieces of adjustment data among digital adjustment data for adjusting a tuning frequency, digital adjustment data for adjusting an oscillation frequency, and digital adjustment data for adjusting a signal level; a selection circuit outputting the adjustment data held by the at least two data holding circuits at different time intervals on a time axis; one D/A converter converting the adjustment data output from the selection circuit into a direct current voltage, and outputting the voltage; and a plurality of voltage holding circuits selectively holding the output voltage of the D/A converter.

According to the above described invention, the adjustment data output from the selection circuit at different time intervals on a time axis can be converted into the direct current voltage by the one D/A converter, and the voltage can be held by the voltage holding circuit of a corresponding adjustment circuit. As a result, the number of D/A converters formed in the semiconductor integrated circuit can be decreased, and the consumed power of the circuit can be reduced.

In the above described invention, in a time period during which the adjustment data are input to the D/A converter, the plurality of voltage holding circuits select the direct current voltages respectively output from the D/A converter, and hold the selected voltage.

As a result, the direct current voltage obtained by D/A-converting the adjustment data input at the different time intervals on the time axis is held by the voltage holding circuit of a corresponding adjustment circuit.

The voltage holding circuit is composed of, for example, a switch and a capacitor, which are configured by MOS transistors.

A further semiconductor integrated circuit for a radio according to the present invention comprises: at least two data holding circuits holding at least two pieces of adjustment data among digital adjustment data for adjusting tracking, digital adjustment data for adjusting an oscillation frequency, digital adjustment data for adjusting the level of a signal for removing a pilot signal, and digital adjustment data for adjusting stereo separation; a selection circuit outputting the adjustment data held by the data holding circuits at different time intervals on a time axis; one D/A converter converting the adjustment data output from the selection circuit into a direct current voltage; and a plurality of voltage holding circuits selectively holding the output voltage of the D/A converter.

According to this invention, the one D/A converter can be used in common to at least two adjustment circuits among a tracking adjustment circuit, an oscillation frequency adjustment circuit, a pilot canceller adjustment circuit, and a stereo separation adjustment circuit, whereby the number of D/A converters formed in the semiconductor integrated circuit can be decreased, and the consumed power can be reduced. Additionally, the digital adjustment data can be changed to adjust to a preferable tuning frequency, oscillation frequency or signal level, thereby simplifying the adjustment operations.

Still further, a semiconductor integrated circuit for a radio according to the present invention comprises: first and second tracking adjustment circuits adjusting a tuning frequency; a first data holding circuit holding digital adjustment data for adjusting the tuning frequency of the first tracking adjustment circuit; a second data holding circuit holding digital adjustment data for adjusting the tuning frequency of the second tracking adjustment circuit; a selection circuit outputting the adjustment data held by the first data holding circuit and the adjustment data held by the second data holding circuit at different time intervals on a time axis; one D/A converter converting the adjustment data output from the selection circuit into a direct current voltage; and a voltage holding circuit, which is provided in the first and the second tracking adjustment circuits, selectively holding the output voltage of the D/A converter.

According to this invention, the tuning frequencies of the plurality of tracking adjustment circuits can be adjusted by using the one D/A converter. As a result, the number of D/A converters formed in the semiconductor integrated circuit can be decreased, and the consumed power can be reduced.

### Brief Description of Drawings

Fig. 1 shows the entire circuit configuration of adjustment circuits;
Fig. 2 is a circuit diagram showing a tracking adjustment circuit;
Fig. 3 is a circuit diagram showing a pilot canceller adjustment circuit;
Fig. 4 is a circuit diagram showing a VCO free run frequency adjustment circuit;
Fig. 5 is a circuit diagram showing a stereo separation adjustment circuit; and
Fig. 6 is a timing chart showing the operations of the circuit.

### Best Mode of Carrying Out the Invention

Hereinafter, a preferred embodiment according to the present invention is described with reference to the drawings. The preferred embodiment described below is an example where the present invention is applied to an FM receiver IC (semiconductor integrated circuit).

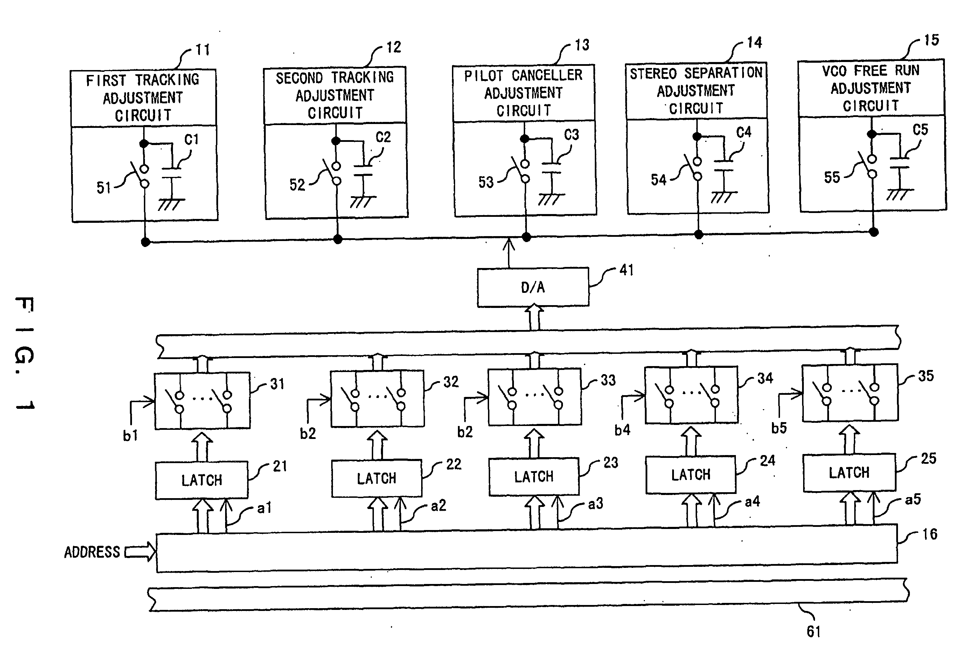

Fig. 1 shows tracking adjustment circuits, a pilot canceller adjustment circuit, a VCO (voltage control oscillator) free run frequency adjustment circuit, a stereo separation adjustment circuit, adjustment data holding units, a D/A converter, etc. for a receiver IC according to the preferred embodiment.

The receiver IC in the preferred embodiment comprises: a latch circuit 21 holding digital adjustment data for adjusting the tuning frequency of a first tracking adjustment circuit 11; a latch circuit 22 holding digital adjustment data for adjusting the tuning frequency of a second tracking adjustment circuit 12; a latch circuit 23 holding the digital adjustment data of a pilot canceller adjustment circuit 13; a latch circuit 24 holding the digital adjustment data of a stereo separation adjustment circuit 14; a latch circuit 25 holding the digital adjustment data of a VCO free run frequency adjustment circuit 15; and an address decoder 16 outputting a signal selecting one of the 5 latch circuits 21 to 25.

The receiver IC further comprises: selection circuits 31 to 35 determining whether or not to output the respective pieces of adjustment data held by the latch circuits 21 to 25 to a D/A converter 41; and the D/A converter 41. The selection circuits 31 to 35 are configured, for example, by analog switches the number of which is equivalent to the number of bits of the adjustment data held by the corresponding latch circuits 21 to 25, and the like.

The receiver IC in this preferred embodiment is configured by a CMOS circuit, and the D/A converter 41 is configured by pluralities of resistors voltage-dividing a reference voltage, and MOS transistors, whereby the consumed power can be made lower than that of a D/A converter configured by bipolar transistors.

The output of the D/A converter 41 is connected to the input sides of an analog switch 51 of the first tracking adjustment circuit 11, an analog switch 52 of the second tracking adjustment circuit 12, an analog switch 53 of the pilot canceller adjustment circuit 13, an analog switch 54 of the stereo separation adjustment circuit 14, and an analog switch 55 of the VCO free run frequency adjustment circuit 15. To the output sides of the analog switches 51 to 55, capacitors C1 to C5 are connected. The analog switches 51 to 55, and the capacitors C1 to C5 are configured, for example, by MOS transistors.

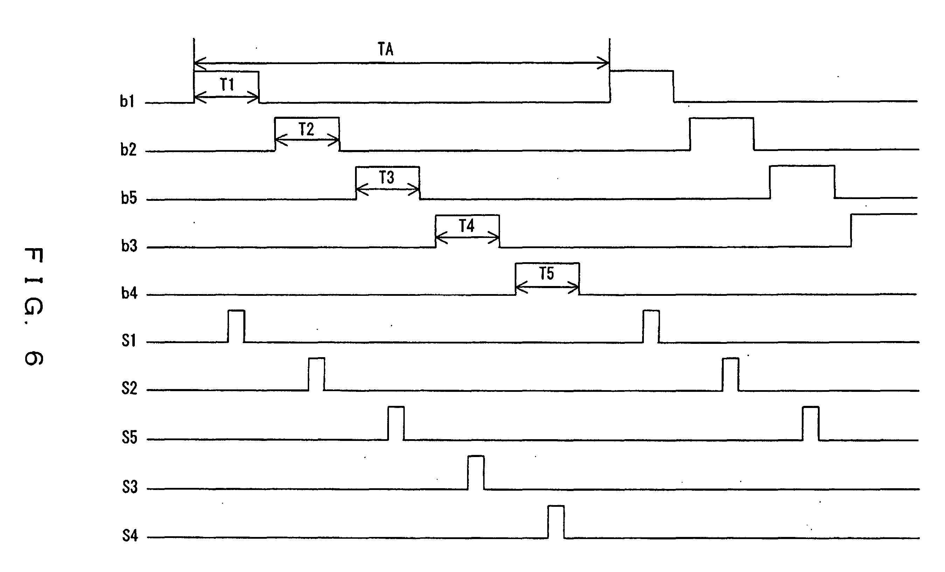

Here, the outline of the operations of the circuit shown in Fig. 1 is described with reference to the timing chart shown in Fig. 6. The following adjustments are made by connecting a computer for the adjustments to an input terminal of the receiver IC, and by inputting address data and adjustment data for adjusting the level of a pilot canceller signal, etc. from the serial input terminal. Upon completion of the adjustments, a CPU within the receiver IC writes optimum digital adjustment data resultant from the adjustments to an internal nonvolatile memory, etc.

A case where the tuning frequency of the first tracking adjustment circuit 11 of a tuning circuit selecting a station is adjusted is described first. In this case, the computer for the adjustments outputs address data which specifies the latch circuit 21 holding the adjustment data of the first tracking adjustment circuit 11, and further outputs digital adjustment data corresponding to the frequency of the station to receive. The address decoder 16 decodes the address data, and outputs a signal a1 that instructs the capturing of the data to the corresponding latch circuit 21. As a result, the latch circuit 21 latches the digital adjustment data for setting the tuning frequency to be output to a data bus 61 within the IC.

At the next time intervals after a predetermined amount of time elapses, address data which specifies the latch circuit 22 corresponding to the second tracking adjustment circuit 12 is output from the computer for the adjustments, and digital adjustment data which specifies the tuning frequency of the second tracking adjustment circuit 12 is further output. The address decoder 16 decodes the address data, and outputs a signal a2 that instructs the capturing of the data to the latch circuit 22. As a result, the digital adjustment data that sets the tuning frequency of the second tracking adjustment circuit 12 is latched by the latch circuit 22.

At the next time intervals, address data that specifies the latch circuit 23 is output, and digital adjustment data for adjusting the signal level of the pilot signal of the pilot canceller adjustment circuit 13 is further output. The address decoder 16 decodes the address data, and outputs a signal a3 that instructs the capturing of the data to the latch circuit 23. As a result, the digital adjustment data that sets the signal level of the pilot signal of the pilot canceller adjustment circuit 13 is latched by the latch circuit 23.

At the next time intervals, address data that specifies the latch circuit 24 is output, and digital adjustment data for adjusting the separation level of stereo separation is further output. The address decoder 16 decodes the address data, and outputs a signal a4 that instructs the capturing of the data to the latch circuit 24. As a result, the adjustment data of the stereo separation is latched by the latch circuit 24.

At the next time intervals, address data that specifies the latch circuit 25 is output, and digital adjustment data that determines the free run frequency of the VCO is further output. The address decoder 16 decodes the address data, and outputs a signal a5 that instructs the capturing of the data to the latch circuit 25. As a result, the adjustment data that determines the free run frequency of the VCO is held by the latch circuit 25.

When the adjustment data are latched by the respective latch circuits 21 to 25, a signal b1 that turns on an analog switch is first fed to the selection circuit 31 during a time period T1 (see Fig. 6), and the adjustment data held by the latch circuit 21 is output to the D/A converter 41. The D/A converter 41 converts the digital adjustment data into a direct current voltage, and outputs the voltage.

At around the half way point of the time period T1. during which the above described direct current voltage is output from the D/A converter 41, a signal S1 that turns on the analog switch 51 of the first tracking adjustment circuit 11 is fed, and the output voltage of the D/A converter 41, namely, a direct current control voltage for adjusting the tuning frequency is charged to the capacitor C1. Thereafter, the analog switch 51 is turned off, and the control voltage of the capacitor C1 is held unchanged. The capacitance of the capacitor C1 is set to a value, with which the preceding control voltage can be held, in a time period TA (time period TA shown in Fig. 6) until the control voltage is output from the D/A converter 41 after the preceding control voltage is output from the D/A converter 41. Also the capacitors C2 to C5 of the other adjustment circuits are set to capacitances that can hold the direct current control voltage output from the D/A converter 41 in a time period (for example, the time period TA) until the control voltage is output next.

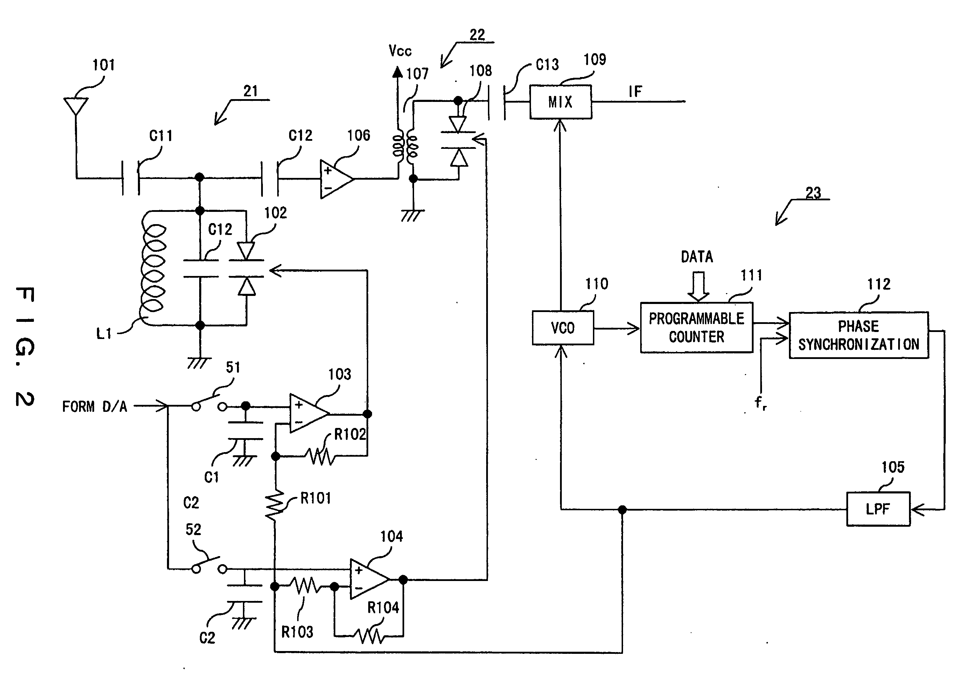

The control voltage of the capacitor C1 is applied to a varactor diode 102 via an operational amplifier 103 of the first tracking adjustment circuit 11 shown in Fig. 2. The capacity of the varactor diode 102 can be varied by changing the control voltage of the capacitor C1.

Accordingly, the adjustment data latched by the latch circuit 21 is changed, and the output voltage of the D/A converter 41, namely, the control voltage of the capacitor C1 is changed, whereby the tuning frequency can be adjusted.

Next, a signal b2 that turns on an analog switch is fed to the selection circuit 32 during a time period T2, and the adjustment data held by the latch circuit 22 is output to the D/A converter 41. The D/A converter 41 converts the digital adjustment data into a direct current voltage, and outputs the voltage. At around the half way point of the time period during which the above described direct current voltage is output from the D/A converter 41, a signal S2 that turns on the analog switch 52 of the second tracking adjustment circuit 12 is fed, and the output voltage of the D/A converter 41, namely, a control voltage for adjusting the tuning frequency of the high-frequency tuning circuit is charged to the capacitor 2. Thereafter, the analog switch 52 is turned off, and the control voltage of the capacitor C2 is held unchanged. The control voltage of the capacitor C2 is applied to a varactor diode 108 via an operational amplifier 104 of the second tracking adjustment circuit 12 shown in Fig. 2. The capacity of the varactor diode 108 can be changed by changing the control voltage of the capacitor C2, whereby the tuning frequency can be adjusted.

Accordingly, the adjustment data latched by the latch circuit 22 is changed, and the output voltage of the D/A converter 41 is changed, whereby the tuning frequency of the tuning circuit 22 can be adjusted.

Next, a signal b5 that turns on an analog switch is fed to the selection circuit 35 during a time period T3, and the adjustment data held by the latch circuit 25 is output to the D/A converter 41. The D/A converter 41 converts the digital adjustment data into a direct current voltage, and outputs the voltage.

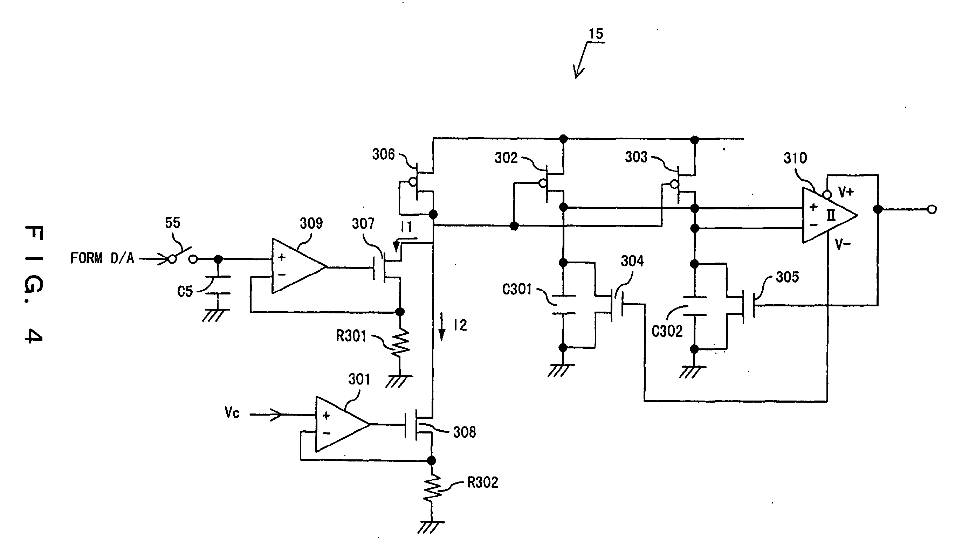

At around the half way point of the time period T3 during which the above described direct current voltage is output from the D/A converter 41, a signal S5 that turns on the analog switch 55 of the VCO free run frequency adjustment circuit 15 is fed, and the output voltage of the D/A converter 41, namely, a control voltage for adjusting the free run frequency of the oscillator (such as the VCO) is charged to the capacitor C5. Thereafter, the analog switch 55 is turned off, and the voltage of the capacitor C5 is held unchanged. The voltage of the capacitor C5 is output to an operational amplifier 309 of the VCO free run frequency adjustment circuit 15 shown in Fig. 4, and the voltage of the capacitor C5 is changed, whereby the free run frequency of the VCO can be adjusted.

Accordingly, the adjustment data latched by the latch circuit 25 is changed, and the output voltage of the D/A converter 41 is changed, whereby the oscillation frequency of the oscillator can be adjusted.

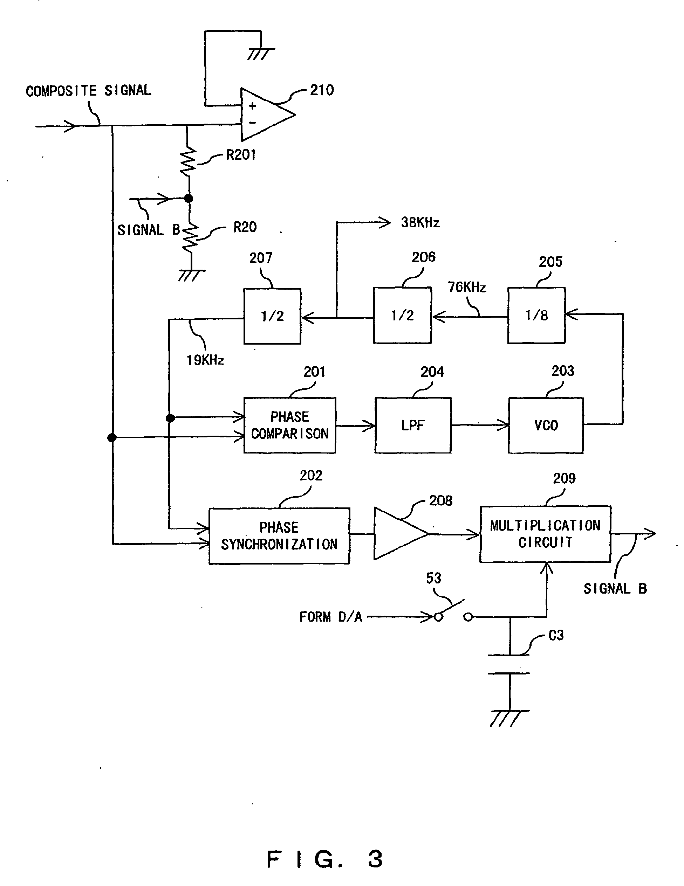

Next, a signal b3 that turns on an analog switch is fed to the selection circuit 33 during a time period T4, and the adjustment data held by the latch circuit 23 is output to the D/A converter 41. The D/A converter 41 converts the digital adjustment data into a direct current voltage, and outputs the voltage. At around the half way point of the time period T4 during which the above described direct current voltage is output from the D/A converter 41, a signal S3 that turns on the analog switch 53 of the pilot canceller adjustment circuit 13 is fed, and the output voltage of the D/A converter 41, namely, a control voltage adjusting the level of a 19-kHz signal for removing a pilot signal is charged to the capacitor C3. Thereafter, the analog switch 53 is turned off, and the control voltage of the capacitor C3 is held unchanged. The control voltage of the capacitor C3 is output to a multiplication circuit 209 of the pilot canceller adjustment circuit 13 shown in Fig. 3. The control voltage of the capacitor C2 is changed, whereby the level of the signal for removing the pilot signal can be adjusted.

Accordingly, the adjustment data latched by the latch circuit 23 is changed, and the output voltage of the D/A converter 41 is changed, whereby the level of the signal for removing the pilot signal can be adjusted.

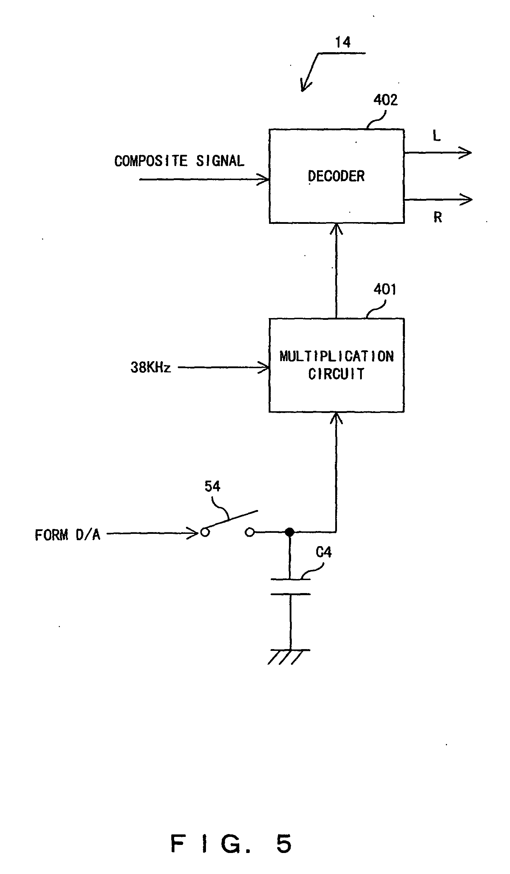

Next, a signal b4 that turns on an analog switch is fed to the selection circuit 34 during a time period T5, and the adjustment data held by the latch circuit 24 is output to the D/A converter 41. The D/A converter 41 converts the digital adjustment data into a direct current voltage, and outputs the voltage. At around the half way point of the time period T5 during which the above described direct current voltage is output from the D/A converter 41, a signal S4 that turns on the analog switch 54 of the stereo separation adjustment circuit 14 is fed, and the output voltage of the D/A converter 41, namely, a control voltage for adjusting the level of a signal adjusting stereo separation is charged to the capacitor 4. Thereafter, the analog switch 54 is turned off, and the control voltage of the capacitor C4 is held unchanged. The control voltage of the capacitor C4 is output to a multiplication circuit 401 of the stereo separation adjustment circuit 15 shown in Fig. 5. The control voltage of the capacitor C4 is changed, whereby the level of the stereo separation can be adjusted.

Accordingly, the adjustment data latched by the latch circuit 24 is changed, and the output voltage of the D/A converter 41 is changed, whereby the level of the stereo separation can be adjusted.

Upon completion of the adjustments of the respective adjustment circuits, final adjustment data is written to the nonvolatile memory. Then, the adjustment data written to the nonvolatile memory is read in predetermined cycles in order (or in different cycles) during normal operations (at the time of reception), and latched by the latch circuits 21 to 25 respectively corresponding to the adjustment circuits. Then, the adjustment data latched by the latch circuits 21 to 25 are output from the selection circuits 31 to 35 to the D/A converter 41 at different time intervals (for example, the time intervals T1 to T5 shown in Fig. 6) on a time axis, and converted into a direct current voltage corresponding to the adjustment data. Then, the output voltage of the D/A converter 41 is respectively held by the voltage holding circuits composed of the analog switches 51 to 55 and the capacitors C1 to C5, and supplied to the respective adjustment circuits 11 to 15 as a control voltage.

In this way, a preferable control voltage can be supplied to the 5 adjustment circuits 11 to 15 by using the one D/A converter 41, whereby the number of D/A converters formed in the semiconductor integrated circuit can be reduced.

Next, one example of the first and the second tracking adjustment circuits 11 and 12 is described with reference to Fig. 2. Fig. 2 shows the circuit including an amplification circuit, a mixing circuit, etc.

An RF signal input from an antenna 101 is input to a capacitor C11. A tuning circuit 21 composed of a coil L1, a capacitor C12, and a varactor diode 102 is connected to the output of a capacitor C12. A signal tuned by the tuning circuit 21 passes through the capacitor C12, is amplified by a high-frequency amplification circuit 106, and input to a tuning circuit 22 composed of a high-frequency transformer 107 and a varactor diode 108.

A signal output from the tuning circuit 22 at the high-frequency amplification stage passes through a capacitor 13, and is converted into an intermediate frequency IF in a mixing circuit 109.

To the varactor diode 102 of the tuning circuit 21, the output voltage of an operational amplifier 103 is applied. The capacitor C1 is connected to a non-inversion input terminal of the operational amplifier 103, whereas the output voltage of a lowpass filter (LPF) 105 of a local oscillation circuit 23 to be described later is input to an inversion input terminal via a resistor R101. Additionally, the output of the operational amplifier 103 is fed back to the inversion input terminal via a resistor R102.

The above described tuning circuit 21, operational amplifier 103, capacitor C1, switch 51, and local oscillation circuit 23 configure the first tracking adjustment circuit 11.

In the first tracking adjustment circuit 11, the output voltage of the D/A converter 41 is charged to the capacitor C1 when the analog switch 51 is turned on, and the charged voltage, namely, the control voltage corresponding to the adjustment data for adjusting tracking is held unchanged, and' applied to the non-inversion terminal of the operational amplifier 103 when the analog switch 51 is turned off.

To the varactor diode 108 of the tuning circuit 22 at the high-frequency amplification stage, the output voltage of an operational amplifier 104 is applied. A capacitor C2 is connected to a non-inversion input terminal of the operational amplifier 104, whereas the output voltage of the lowpass filter 105 of the local oscillation circuit 23 is input to an inversion input terminal via a resistor R103. Additionally, the output of the operational amplifier 104 is fed back to the inversion input terminal via a resistor R104.

The above described tuning circuit 22, operational amplifier 104, capacitor C2, analog switch 52, and local oscillation circuit 23 configure the second tracking adjustment circuit 12.

In the second tracking adjustment circuit 12, the output voltage of the D/A converter 41 is charged to the capacitor C2 when the analog switch 52 is turned on, and the charged voltage, namely, the control voltage corresponding to the adjustment data for adjusting tracking is held unchanged, and applied to the non-inversion input terminal of the operational amplifier 104 when the analog switch 52 is turned off.

The local oscillation circuit 23 is composed of a VCO 110, a programmable counter 111, a phase comparator 112, and a lowpass filter 105.

A count value corresponding to the frequency of a station desired to receive is set in the program counter 111, and a signal obtained by frequency-dividing the oscillation frequency of the VCO 110 according to the set count value is output to the phase comparator 112.

The phase comparator 112 makes a comparison between the output signal of the programmable counter 111 and a reference frequency fr, and outputs to the lowpass filter 105 a direct current voltage in a pulse form indicating the phase difference between the output signal and the reference frequency, and the direction of a phase lead or lag. Then, that voltage is output from the lowpass filter 105 to the VCO 110 as a direct current control voltage for controlling the oscillation frequency in a plus or minus direction. The above described operations are repeated, so that the oscillation frequency of the VCO 110 is converged to a target frequency.

If the tuning frequency of the tuning circuit 21 is adjusted, the adjustment data to be set in the latch circuit 21 shown in Fig. 1 is successively changed in a state where data with which the frequency of a station desired to receive is converted into an intermediate frequency IF is set in the programmable counter 11, and the output voltage of the D/A converter 41 is changed. Namely, the control voltage applied to the varactor diode 102 is changed to adjust the tuning frequency. After the control voltage which implements an optimum tuning frequency is obtained, the adjustment data at that time is written to a storage unit (nonvolatile memory, etc.) within the receiver IC as the adjustment data of the tuning frequency of the station desired to receive. Thereafter, the adjustment of a tuning frequency is similarly made also for other frequencies desired to receive.

Also in the tuning circuit 22 at the high-frequency amplification stage, the adjustment data to be set in the latch circuit 21 shown in Fig. 1 is successively changed in a state where desired data is set in the programmable counter 111. After the control voltage implementing an optimum tuning frequency can be identified, the adjustment data at that time is written to the nonvolatile memory within the receiver IC as the adjustment data of the tuning frequency of the station desired to receive.

Fig. 3 shows one example of the pilot canceller adjustment circuit 13.

To one input terminals of a phase comparison circuit 201 and a phase synchronization circuit 202, a stereo composite signal obtained by making FM detection is input. To the other input terminals, a 19-kHz signal obtained by frequency-dividing the oscillation frequency of a VCO 203 with a 1/8 frequency division circuit 205, a 1/2 frequency division circuit 206, and a 1/2 frequency division circuit 207 is input.

The phase comparison circuit 201 makes a comparison between the phase of a 19-kHz pilot signal of the composite signal and that of the 19-kHz signal obtained by frequency-dividing the signal generated by the VCO 203, and outputs a voltage according to the phase difference between these signals to a lowpass filter (LPF) 204. Then, the voltage is output from the lowpass filter 204 as a control voltage for controlling the oscillation frequency of the VCO 203.

In the above described circuit, the oscillation frequency is PLL-controlled in a direction where the phase of the pilot signal and that of the 19-kHz signal generated within the IC match. Accordingly, a 38-kHz signal obtained by frequency-dividing the signal generated by the VCO 203 can be synchronized with the pilot signal of the composite signal.

The phase synchronization circuit 202 synchronizes the 19-kHz signal obtained by frequency-dividing the signal generated by the VCO 203 with the pilot signal of the stereo composite signal, and outputs the synchronized signal to an analog inverter 208. Then, the signal is inverted by the analog inverter 208, and the signal that has the same frequency as that of the pilot signal and the inverted phase is output to a multiplication circuit 209.

To the other input terminal of the multiplication circuit 209, the voltage of the capacitor C3, namely, the control voltage for adjusting the signal level of the pilot canceller adjustment circuit 13 is input. Then, the two input signals are multiplied, and a signal resultant from the multiplication is voltage-divided by resistors R201 and R202, and input to an inversion input terminal of an operational amplifier 210. To a non-inversion input terminal of the operational amplifier 210, the composite signal is input.

To remove the pilot signal from the composite signal, a signal that has a signal level matching the pilot signal and an inverse phase must be applied.

The pilot canceller adjustment circuit 13 shown in Fig. 3 is intended to make an adjustment in order to match the signal level of the 19-kHz signal output from the multiplication circuit 209 with the signal level of the pilot signal by changing the adjustment data, and by changing the output voltage of the D/A converter 41.

To implement this, in this preferred embodiment, the digital adjustment data latched by the latch circuit 23 shown in Fig. 1 is successively changed, the output waveform of the operational amplifier 210 at that time is monitored, and the adjustment data when the pilot signal can be removed from the composite signal is written to the nonvolatile memory, etc. within the receiver IC. In this way, the adjustment of the pilot canceller adjustment circuit 13 can be automatically made.

After the adjustment is terminated, the adjustment data stored in the nonvolatile memory within the IC is read, set in the latch circuit 23, and read in predetermined cycles, whereby the pilot signal can be removed.

Fig. 4 shows one example of the VCO free run frequency adjustment circuit 14. This VCO free run frequency adjustment circuit 14 is used, for example, as the VCO 203 of the pilot canceller adjustment circuit 13 shown in Fig. 3. The output voltage of the lowpass filter 204 of the circuit shown in Fig. 3 is input as an input voltage Vc of a non-inversion input terminal of an operational amplifier 301.

In the VCO free run frequency adjustment circuit 15 shown in Fig. 4, P-type FETs 302 and 303, N-type FETs 304 and 305, capacitors C301 and C302, and a Schmitt circuit 310 configure an oscillation circuit. The oscillation frequency of this oscillation circuit can be changed by controlling an electric current flowing into a P-type FET 306. The electric current flowing into the P-type FET 306 is the sum of an electric current I1 flowing into an N-type FET 307, and an electric current I2 flowing into an N-type FET 308.

The electric current I1 flowing into the N-type FET 307 is determined by the values of an input voltage (the output voltage of the D/A converter 41) of a non-inversion input terminal of an operational amplifier 309 and a resistor R301. Additionally, the electric current flowing into the N-type FET 308 is determined by the values of the input voltage Vc (the output voltage of the lowpass filter 204) of the non-inversion input terminal of the operational amplifier 301 and the resistor R202.

Namely, the adjustment data is successively changed, the free run frequency of the oscillator is changed by controlling the electric current of the N-type FET 307, and the oscillation frequency at that time is measured. Then, the adjustment data when the oscillation frequency becomes a target frequency is written to the nonvolatile memory within the receiver IC. In this way, the adjustment of the free run frequency of the oscillator can be automatically made.

Fig. 5 shows one example of the stereo separation adjustment circuit. To a multiplication circuit 401, the 38-kHz signal generated by the pilot canceller adjustment circuit 13 shown in Fig. 3, and the output voltage of the D/A converter 41 are input. These signals are multiplied and output to a decoder 402. The decoder 402 separates the stereo composite signal into L and R signals according to a signal level output from the multiplication circuit 401.

The output voltage of the D/A converter 41 can be changed with the adjustment data set in the latch circuit 24 as described above. Therefore, the value of the adjustment data, with which optimum separation is obtained, can be determined by successively changing the adjustment data, and by measuring the L and R signals output from the decoder 402 at that time. After the optimum adjustment data is obtained, the adjustment data at that time is written to the nonvolatile memory, etc. within the receiver IC.

According to the above described preferred embodiment, all of the adjustments of the first and the second tracking adjustment circuits 11 and 12, the pilot canceller adjustment circuit 13, the stereo separation adjustment circuit 14, and the VCO free run frequency adjustment circuit 15 can be made by using the one D/A converter 41. Additionally, after the adjustments are completed, a preferable control voltage can be supplied from the one D/A converter 41 to the respective adjustment circuits.

Accordingly, the number of used D/A converters 41 the consumed power of which is high when being put into an IC can be decreased, and the consumed power of the semiconductor integrated circuit can be reduced. Additionally, the adjustments of a tuning frequency, a signal level, an oscillation frequency, etc. can be made by using the D/A converter 41, thereby eliminating the need for manually adjusting coils, capacitors, etc., which are externally attached to an IC, as conventional. Furthermore, also a plurality of receivers whose frequency channels for receiving are different can be supported by one receiver IC by means of changing the adjustment data.

The present invention is not limited to the above described preferred embodiment. The present invention may be configured as follows.
(a) In the preferred embodiment, the adjustments of the first tracking adjustment circuit 11, the second tracking adjustment circuit 12, the pilot canceller adjustment circuit 13, the stereo separation adjustment circuit 14, and the VCO free run frequency adjustment circuit 15 are made with the one D/A converter 41. However, the number of used D/A converters is not limited to one. A plurality of D/A converters may be used.
   Additionally, one D/A converter may be used for each adjustment circuit. In this case, an effect such that the adjustment of a tuning frequency, the adjustment operations of an oscillation frequency, etc. can be simplified without making adjustments of the capacitance of an externally attached capacitor, etc. is obtained although the number of used D/A converters is not decreased.
(b) The adjustment circuits are not limited to the circuits referred to in the preferred embodiment. The present invention can be applied to a circuit if it requires an adjustment in a used receiver and transmitter.
(c) The circuit holding the output voltage of the D/A converter 41 is not limited to a circuit configured by a capacitor and an analog switch. Any circuit may be available if it can hold a voltage. For example, a circuit using an operational amplifier, etc. may be available.
(d) The respective adjustment circuits are not limited to the circuits referred to in the preferred embodiment. Other known adjustment circuits may be available.
(e) There is no need to provide the selection circuits 31 to 35 by a number corresponding to the latch circuits 21 to 25. For example, one selector may select and output one piece of the data of the latch circuits 21 to 25.
(f) The present invention can be applied to a radio that is not put into an IC, a radio where part of the above described circuit is put into an IC, and a semiconductor integrated circuit for a radio.
(g) In the preferred embodiment, the 5 latch circuits 21 to 25 respectively latching the adjustment data are provided for the 5 adjustment circuits 11 to 15. However, the number of latch circuits may be reduced, for example, to one, and the adjustment data of a plurality of adjustment circuits may be written to the latch circuit at different time intervals on a time axis (for example, the adjustment data of the respective adjustment circuits are written ih order as in the preferred embodiment). In this case, the adjustment data held by the latch circuit can be also directly output to the D/A converter, which eliminates the need for providing an analog switch (selection circuit) switching the output of the latch circuit.
(h) The present invention can be applied to adjustment circuits of various types of radio circuits such as a receiver and a transmitter for a wireless communication, a cellular phone, a wireless LAN, etc., without being limited to an AM/FM receiver.

According to the present invention, a D/A converter can be used in common to a plurality of adjustment circuits, whereby the number of D/A converters can be decreased, and the consumed power of the circuit can be reduced.

## Claims

1. A semiconductor integrated circuit for a radio, comprising:
one D/A converter, to which a plurality of pieces of digital adjustment data for adjusting direct current voltages of a plurality of adjustment circuits requiring a voltage adjustment are input at different time intervals on a time axis, converting the adjustment data into a direct current voltage, and outputting the voltage; and
a voltage holding circuit, which is provided in each of the plurality of adjustment circuits, selectively holding the direct current voltage output from said D/A converter.

2. A semiconductor integrated circuit for a radio, comprising:
one D/A converter, to which at least two pieces of adjustment data among digital adjustment data for adjusting a tuning frequency, digital adjustment data for adjusting an oscillation frequency, and digital adjustment data for adjusting a signal level are input at different time intervals on a time axis, converting the adjustment data into a direct current voltage, and outputting the voltage; and
a plurality of voltage holding circuits selectively holding the output voltage of said D/A converter.

3. A semiconductor integrated circuit for a radio, comprising:
a data holding circuit holding a plurality of pieces of digital adjustment data for adjusting voltages of a plurality of adjustment circuits requiring a voltage adjustment at different time intervals on a time axis;
one D/A converter converting the adjustment data output from said data holding circuit into a direct current voltage; and
a voltage holding circuit, which is provided in each of the plurality of adjustment circuits, selectively holding an output voltage of said D/A converter.

4. A semiconductor integrated circuit for a radio, comprising:
a plurality of data holding circuits holding a plurality of pieces of digital adjustment data for adjusting voltages of a plurality of adjustment circuits requiring a voltage adjustment;
a selection circuit outputting the adjustment data held by said plurality of data holding circuits at different time intervals on a time axis;
one D/A converter converting the adjustment data output from said selection circuit into a direct current voltage; and
a voltage holding circuit, which is provided in each of the adjustment circuits, selectively holding an output voltage of said D/A converter.

5. A semiconductor integrated circuit for a radio, comprising:
at least two data holding circuits holding at least two pieces of adjustment data among digital adjustment data for adjusting a tuning frequency, digital adjustment data for adjusting an oscillation frequency, and digital adjustment data for adjusting a signal level;
a selection circuit outputting the adjustment data held by at least said two data holding circuits at different time intervals on a time axis;
one D/A converter converting the adjustment data output from said selection circuit into a direct current voltage; and
a plurality of' voltage holding circuits selectively holding an output voltage of said D/A converter.

6. The semiconductor integrated circuit for a radio according to any one of claims 1 to 5, wherein
said plurality of voltage holding circuits select the direct current voltage output from said D/A converter in correspondence with temporal time intervals at which each piece of the adjustment data is input, and hold the voltage.

7. The semiconductor integrated circuit for a radio according to any one of claims 1 to 6, wherein
said voltage holding circuit is composed of a switch and a capacitor, which are configured by MOS transistors.

8. A semiconductor integrated circuit for a radio, comprising:
at least two data holding circuits holding at least two pieces of adjustment data among digital adjustment data for adjusting tracking, digital adjustment data for adjusting an oscillation frequency, digital adjustment data for adjusting a level of a signal for removing a pilot signal, and digital adjustment data for adjusting stereo separation;
a selection circuit outputting the adjustment data held by said data holding circuits at different time intervals on a time axis;
one D/A converter converting the adjustment data output from said selection circuit into a direct current voltage; and
a voltage holding circuit selectively holding an output voltage of said D/A converter.

9. A semiconductor integrated circuit for a radio, comprising:
first and second tracking adjustment circuits adjusting a tuning frequency;
a first data holding circuit holding digital adjustment data for adjusting a tuning frequency of said first tracking adjustment circuit;
a second data holding circuit holding digital adjustment data for adjusting a tuning frequency of said second tracking adjustment circuit;
a selection circuit outputting the adjustment data held by said first data holding circuit, and the adjustment data held by said second data holding circuit at different time intervals on a time axis;
one D/A converter converting the adjustment data output from said selection circuit into a direct current voltage; and
a voltage holding circuit, which is provided in each of said first and said second tracking adjustment circuits, selectively holding an output voltage of said D/A converter.

10. A semiconductor integrated circuit for a radio, comprising:
a first D/A converter, to which digital adjustment data for adjusting a direct current voltage of a first adjustment circuit requiring a voltage adjustment is input, converting the adjustment data into a direct current voltage, and outputting the voltage; and
a second D/A converter, to which digital adjustment data for adjusting a direct current voltage of a second adjustment circuit requiring a voltage adjustment is input, converting the adjustment data into a direct current voltage, and outputting the voltage.

11. Radio communications equipment, comprising:
one D/A converter, to which a plurality of pieces of digital adjustment data for adjusting direct current voltages of a plurality of adjustment circuits requiring a voltage adjustment are input at different time intervals on a time axis, converting the adjustment data into a direct current voltage, and outputting the voltage; and
a voltage holding circuit, which is provided in each of the plurality of adjustment circuits, selectively holding the direct current voltage output from said D/A converter.
